# EUROPÄISCHE PATENTSCHRIFT

(11) **EP 2 928 685 B1**
(45) Veröffentlichungstag und Bekanntmachung des Hinweises auf die Patenterteilung: **31.10.2018**
(21) Anmeldenummer: 13814056.1
(22) Anmeldetag: 03.12.2013
(51) Int. Cl.: F16C 33/14, B32B 15/01, C23C 14/16, C23C 28/02, F16C 33/12, C22C 9/02, C22C 9/04, C22C 9/06, C22C 21/00, C22C 9/01

(54) **GLEITLAGERVERBUNDWERKSTOFF**
SLIDING BEARING COMPOSITE MATERIAL
MATÉRIAU COMPOSITE DE PALIER LISSE

(30) Priorität: 05.12.2012 DE 102012222327
(43) Veröffentlichungstag der Anmeldung: 14.10.2015
(73) Patentinhaber: KS Gleitlager GmbH, 68789 St. Leon-Rot (DE)
(72) Erfinder: KYRSTA, Stepan, 52072 Aachen (DE); PUCHER, Klaus, 86420 Diedorf (DE); LANGNER, Heinbert, 33378 Rheda-Wiedenbrück (DE); SCHUBERT, Werner, 69168 Wiesloch (DE)
(74) Vertreter: DREISS Patentanwälte PartG mbB
(86) Internationale Anmeldenummer: PCT/EP2013/075360
(87) Internationale Veröffentlichungsnummer: WO 2014/086767

(56) Entgegenhaltungen:
- WO-A1-96/04485
- AT-A4- 511 196
- DE-A1- 3 727 591
- DE-A1-102005 023 306
- DE-A1-102011 013 883

## Beschreibung

Die Erfindung betrifft einen metallischen Gleitlagerverbundwerkstoff mit einer Stützschicht, insbesondere aus Stahl, einer Kupferbasis-Schicht mit Zinn oder Aluminium oder Nickel oder Zink oder Kombinationen hieraus und mit einer einem Gleitpartner zugewandten gesputterten Laufschicht, insbesondere auf Aluminiumbasis. Derartige Gleitlagerverbundwerkstoffe sind bekannt, beispielsweise aus DE 10 2011 013 883 A1 oder aus DE 10 2005 023 306 A1. Sie finden typischerweise in motorischen und motorennahen Anwendungen in der Kraftfahrzeugindustrie Verwendung, beispielsweise zur Herstellung von Kurbelwellenlagerschalen und Pleuellagerschalen und - buchsen. AT 511 196 A4 befasst sich mit einer nicht gattungsgemäßen Lagerschale mit einer tragenden dicken Rücken- oder Stützschicht aus Zinnbronze, die stranggegossen und gewalzt ist, und auf der wenigstens eine weitere Lagermetallschicht und/oder Gleitschicht und/oder Diffusionssperrschicht durch eine Vielzahl von Verfahren, insbesondere auch Sputterverfahren, aufgebracht sein kann. DE 37 27 591 betrifft einen nicht gattungsgemäßen Gleitlagerverbundwerkstoff mit einer Kupferbasis-Schicht und einer galvanisch abgeschiedenen Laufschicht.

Gleitlager aus einem Gleitlagerverbundwerkstoff mit einer gesputterten Laufschicht haben sich insbesondere bei der Verwendung unter höchsten Belastungen bewährt. Aufgrund ihres vorstehend beschriebenen Aufbaus werden sie auch als sogenannte "Dreistofflager" bezeichnet, obschon sie weitere sehr dünne Zwischenbindungsschichten und/oder Diffusionssperrschichten zumeist auf Nickelbasis aufweisen können. Bei typischen vorbekannten Gleitlagerverbundwerkstoffen wird die Kupferbasis-Schicht, die zwischen der Stützschicht und der Laufschicht angeordnet ist, üblicherweise als Lagermetallschicht bezeichnet; sie weist eine nicht unerhebliche Dicke von meist über 150 µm auf und ist auf die Stützschicht aufgesintert, aufplattiert oder aufgegossen. Auf dieser Lagermetallschicht kann je nach deren Zusammensetzung eine dünne Diffusionssperrschicht einer Dicke von nur einigen µm aufgebracht werden. Auf diese Diffusionssperrschicht ist die Laufschicht, typischerweise auf Aluminiumbasis, aufgesputtert. Wenn vorliegend von Sputtern die Rede ist, so wird hierunter ein Beschichtungsverfahren verstanden, bei dem aus einem Festkörper (Target) durch Beschuss mit Ionen Atome herausgeschlagen werden, die gewissermaßen in die Gasphase übergehen und dann auf einem zu beschichtenden Substrat abgelagert werden. Sputtern wird häufig auch als Kathodenzerstäubung bezeichnet, da der Festkörper dabei kathodisch geschaltet ist. Sputterschichten oder gesputterte Schichten werden so durch möglichst gleichmäßige Ablagerung oder Abscheidung auf dem Substrat aufgebaut.

Der vorliegenden Erfindung liegt die Aufgabe zugrunde, einen Gleitlagerverbundwerkstoff der vorstehend geschilderten Art auf einfachere und wirtschaftlichere Weise herzustellen.

Diese Aufgabe wird durch einen Gleitlagerverbundwerkstoff gelöst, der erfindungsgemäß dadurch gekennzeichnet ist, dass die Kupferbasis-Schicht eine gesputterte Schicht ist und eine Dicke von wenigstens 20 µm aufweist und dass die Kupferbasis-Schicht direkt auf die Stützschicht oder auf eine direkt auf die Stützschicht aufgebrachte Zwischenschicht einer Dicke von weniger als 20 µm, insbesondere von weniger als 10 µm aufgesputtert ist.

Mit der vorliegenden Erfindung wurde überraschend festgestellt, dass die bei vorbekannten Gleitlagerverbundwerkstoffen verhältnismäßig dicke aufgesinterte, aufplattierte oder aufgegossene Lagermetallschicht auf Kupferbasis weggelassen oder ersetzt werden kann durch eine verhältnismäßig dünne aufgesputterte Kupferbasis-Schicht. Hierdurch werden auch die limitierenden Beschränkungen der bisher verwendeten Verfahren Aufsintern, Aufgießen und Aufplattieren hinsichtlich der verwendbaren Legierungszusammensetzungen umgangen. Verglichen mit der Dicke typischer Sputterschichten im Bereich von Gleitlagerverbundwerkstoffen ist die aufgesputterte Kupferbasis-Schicht mit wenigstens 20 µm, vorzugsweise wenigstens 25 µm, weiter vorzugsweise wenigstens 30 µm außergewöhnlich dick. Die Kupferbasis-Schicht hat eine bevorzugte Dicke von 20 µm - 80 µm, insbesondere von 25 µm - 70 µm, insbesondere von 30 µm bis 70 µm, insbesondere von 30 µm bis 60 µm, insbesondere von 30 µm bis 50 µm aufweist. Verglichen mit vorbekannten, aufgesinterten, aufplattierten oder aufgegossenen Lagermetallschichten ist die Schichtdicke der aufgesputterten Kupferbasis-Schicht jedoch eher gering. Mit der vorliegenden Erfindung wurde erkannt, dass sich Kupferbasis-Legierungen im Vergleich zu Aluminiumbasis-Legierungen rascher im Sputterverfahren aufbauen lassen und dass sich dies im Sinne der vorliegenden Erfindung zu einer sehr wirtschaftlichen Herstellbarkeit von Gleitlagerverbundwerkstoffen des beanspruchten Aufbaus einsetzen lässt. Sofern die zwei gesputterten Schichten in einer als Mehrkammeranlage ausgestatteten Sputteranlage gefertigt werden, bietet dies die Möglichkeit, unter Minimierung von Wartezeiten den Gleitlagerverbundwerkstoff herzustellen, indem in ungefähr demselben Zeitraum, in dem die Laufschicht aufgesputtert wird, die demgegenüber deutlich dickere Kupferbasis-Schicht in einer vorgeordneten Kammer der Sputteranlage aufgebracht wird. Es kommt so nicht zu unerwünschten Wartezeiten bei der Ausführung der Sputterprozesse. Sofern eine geeignete Mehrkammeranlage zur Verfügung steht, könnte die Aufbringung der Kupferbasis-Schicht auch in zwei parallel zueinander betreibbaren Kammern ausgeführt werden, die abwechselnd beschickt bzw. entleert werden und der nachfolgenden Kammer zum Aufsputtern der Laufschicht vorgeordnet sind. Auch so wäre eine kontinuierliche wartezeitfreie Fertigung bei geeigneter Wahl der Schichtdicken und Sputterzeiten denkbar. Erfindungsgemäß kann auf die herkömmliche aufgesinterte, aufplattierte oder aufgegossene dicke Lagermetallschicht gänzlich verzichtet werden, was eine erhebliche Materialersparnis mit sich bringt und auch die Fertigungskosten deutlich reduziert. Des Weiteren stellt es sich in überraschender Weise heraus, dass die gegenüber herkömmlichen aufplattierten, aufgesinterten oder aufgegossenen Lagermetallschichten verhältnismäßig dünne gesputterte Kupferbasis-Schicht dennoch eine gute Partikelverträglichkeit und eine gute Anpassungsfähigkeit sowie gute Notlaufeigenschaften aufweist, was nicht ohne weiteres anzunehmen war.

Nach einer bevorzugten Ausführungsform der vorliegenden Erfindung ist die Kupferbasis-Schicht von einer CuSn(3-10)Ni(0-18)-Legierung, insbesondere von einer CuSn(3-10)Ni(5-18)-Legierung, insbesondere von einer CuSn(5-7)Ni(8-10)-Legierung oder von einer CuSn(7-10)Ni(13-16)-Legierung, gebildet, insbesondere von einer CuSn6Ni9 oder einer CuSn8Ni15-Legierung. In der alternativen Ausführung der Erfindung ist die Kupferbasis-Schicht von einer CuAl(4-10)-Legierung oder von einer CuZn(10-35)-Legierung gebildet.

Die mit dem Gleitpartner zusammenwirkende gesputterte Laufschicht ist vorteilhafterweise von einer AlSn(17-27)Cu(0,5-3)-Legierung, insbesondere von einer AlSn(18-22)Cu(0,5-1,5), insbesondere AlSn20Cu-Legierung, oder von einer AlSn(24-26)Cu(2-3)-Legierung, insbesondere AlSn25Cu2,5-Legierung, gebildet. Auch gesputterte Laufschichten aus einer AlBi-Legierung oder aus einer SnCu- oder SnSb-Legierung oder aus einer Bi-Legierung sind denkbar.

Die Dicke der Laufschicht beträgt zweckmäßigerweise 5 - 25 µm, insbesondere 5 - 20 µm, insbesondere 6 - 18 µm, insbesondere 7 - 15 µm.

Nach einer besonders bevorzugten Ausführungsform der Erfindung umfasst die Kupferbasis-Schicht Zinn und Nickel und ist insbesondere von einer CuSn(3-10)Ni(0-18)-Legierung gebildet. Es erweist sich dann als besonders vorteilhaft, dass die Laufschicht ohne Zwischenordnung einer weiteren Diffusionssperrschicht direkt auf die zuvor aufgesputterte Kupferbasis-Schicht aufgesputtert werden kann, ohne dass es zu störenden Diffusionsvorgängen zwischen der aufgesputterten Laufschicht und der aufgesputterten Kupferbasis-Schicht kommt.

Sofern die Kupferbasis-Schicht eine niedriglegierte CuSn-Legierung umfasst, insbesondere von einer CuSn(4-10)-Legierung gebildet ist, so erweist es sich als vorteilhaft, wenn zwischen der Kupferbasis-Schicht und der Laufschicht eine Diffusionssperrschicht einer Dicke von höchstens
10 µm, insbesondere von höchstens 8 µm, insbesondere von höchstens 6 µm vorgesehen ist.

Es sei darauf hingewiesen, dass die Angaben der Legierungen nicht ausschließen, dass weitere Legierungsbestandteile enthalten sein können. Legierungen der genannten Zusammensetzung werden aber bevorzugt. Es sind auch in der Regel verunreinigungsbedingte Bestandteile von jeweils < 0,1 Gew.-% enthalten, die in der Summe jedoch nicht mehr als 1 Gew.-% der Zusammensetzung ausmachen.

Die Erfindung betrifft des Weiteren Gleitlagerelemente, insbesondere Gleitlagerschalen und Gleitlagerbuchsen, die aus einem flächenhaft erstreckten Gleitlagerverbundwerkstoff in einem Biegerollprozess geformt werden. Des Weiteren betrifft die Erfindung ein Verfahren zum Herstellen eines Gleitlagerverbundwerkstoffs mit den Merkmalen des Anspruchs 11.

Weitere Merkmale, Einzelheiten und Vorteile der Erfindung ergeben sich aus den beigefügten Patentansprüchen, der zeichnerischen Darstellung und nachfolgenden Beschreibung einer bevorzugten Ausführungsform des erfindungsgemäßen Gleitlagerverbundwerkstoffs.

In der Zeichnung zeigt:
- Figur 1: eine schematische Schnittansicht eines erfindungsgemäßen metallischen Gleitlagerverbundwerkstoffs und
- Figur 2: eine schematische Schnittansicht einer weiteren Ausführungsform eines erfindungsgemäßen metallischen Gleitlagerverbundwerkstoffs.

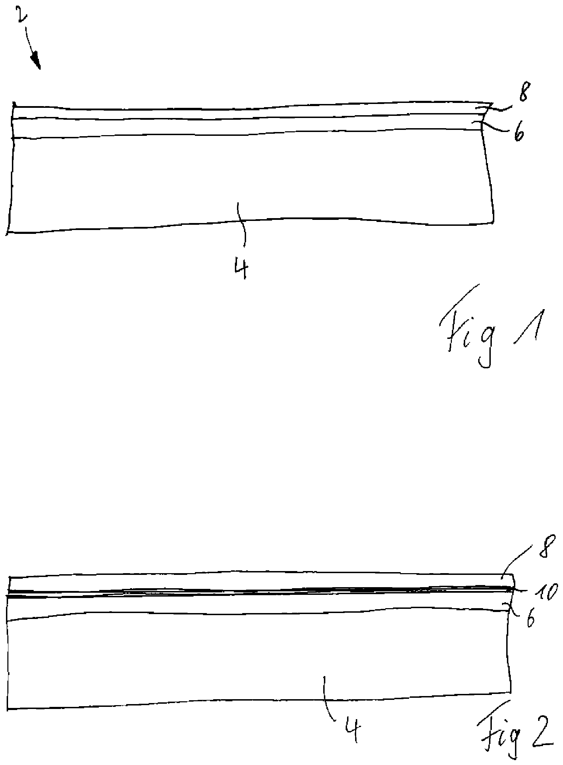

Figur 1 zeigt eine schematische größenmäßig nicht skalierte Schnittansicht eines erfindungsgemäßen Gleitlagerverbundwerkstoffs 2 für die Herstellung von metallischen Gleitlagerelementen, insbesondere Gleitlagerschalen und -buchsen in einem Biegerollprozess. Der Gleitlagerverbundwerkstoff umfasst eine Stützschicht 4, typischerweise aus Stahl. Auf die Oberseite der zuvor insbesondere durch Beschuss mit Edelgasionen gereinigten Oberseite der Stützschicht 4 ist vorzugsweise unmittelbar eine Kupferbasis-Schicht 6 aufgesputtert. Diese Kupferbasis-Schicht kann die eingangs beschriebene Zusammensetzung haben. Ihre Dicke beträgt vorzugsweise zwischen 20 µm und 80 µm, vorzugsweise 25 µm - 70 µm. Sofern die Kupferbasis-Schicht eine Kupfer-Zinn-NickelLegierung ist, so ist eine weitere Diffusionssperrschicht entbehrlich, und es kann eine Laufschicht 8, insbesondere auf Aluminiumbasis, vorzugsweise mit Zinn und Kupfer, unmittelbar auf die Kupferbasis-Schicht 6 aufgesputtert werden. Ihre Schichtdicke ist mit 5 - 25 µm vorzugsweise geringer als die Schichtdicke der Kupferbasis-Schicht 6. Insgesamt erweist sich der erfindungsgemäße Gleitlagerverbundwerkstoff als hochbelastbar. In diesem Fall fungiert die Kupferbasis-Schicht gewissermaßen als Ersatz für eine herkömmliche dicke Lagermetallschicht, und sie übt des Weiteren die Funktion einer Diffusionssperrschicht zur Verhinderung von Zinndiffusion aus der Laufschicht aus.

Sofern die Kupferbasis-Schicht 6 nur Zinn an Stelle von Zinn und Nickel enthält, erweist es sich als vorteilhaft, zwischen der Kupferbasis-Schicht 6 und der Laufschicht 8 eine zusätzliche Diffusionssperrschicht 10 einer Dicke von wenigen µm und einer üblichen Zusammensetzung, etwa auf Nickelbasis oder Zinnnickelbasis oder Kupfernickelzinn-Basis vorzusehen. Diese Diffusionssperrschicht 10 kann auch aufgesputtert werden. Ein solcher Gleitlagerverbundwerkstoff ist in Figur 2 dargestellt.

## Patentansprüche

1. Metallischer Gleitlagerverbundwerkstoff (2) mit einer Stützschicht (4), insbesondere aus Stahl, einer Kupferbasis-Schicht (6) mit Zinn oder Aluminium oder Nickel oder Zink oder Kombinationen hieraus und mit einer einem Gleitpartner zugewandten gesputterten Laufschicht (8) auf Aluminiumbasis, **dadurch gekennzeichnet, dass** die Kupferbasis-Schicht (6) eine gesputterte Schicht ist und eine Dicke von 20 µm bis 80 µm aufweist und dass die Kupferbasis-Schicht (6) direkt auf die Stützschicht (4) oder auf eine direkt auf die Stützschicht (4) aufgebrachte Zwischenschicht einer Dicke von weniger als 20 µm aufgesputtert ist.

2. Gleitlagerverbundwerkstoff nach Anspruch 1, **dadurch gekennzeichnet, dass** die Kupferbasis-Schicht (6) eine Dicke von 25 µm bis 70 µm, insbesondere von 30 µm bis 70 µm, insbesondere von 30 µm bis 60 µm, insbesondere von 30 µm bis 50 µm aufweist.

3. Gleitlagerverbundwerkstoff nach Anspruch 1 oder 2, **dadurch gekennzeichnet, dass** die Kupferbasis-Schicht (6) von einer CuSn(3-10)Ni(0-18)-Legierung, insbesondere von einer CuSn(3-10)Ni(5-18)-Legierung, insbesondere von einer CuSn(5-7)Ni(8-10)-Legierung oder von einer CuSn(7-10)Ni(13-16)-Legierung, gebildet ist, insbesondere von einer CuSn6Ni9 oder einer CuSn8Ni15-Legierung gebildet ist.

4. Gleitlagerverbundwerkstoff nach Anspruch 1, 2 oder 3, **dadurch gekennzeichnet, dass** die Kupferbasis-Schicht (6) von einer CuAl(4-10)-Legierung oder von einer CuZn(10-35)-Legierung gebildet ist.

5. Gleitlagerverbundwerkstoff nach einem oder mehreren der vorstehenden Ansprüche, **dadurch gekennzeichnet, dass** die Laufschicht (8) von einer AlSn(17-27)Cu(0,5-3)-Legierung, insbesondere von einer AlSn(18-22)Cu(0,5-1,5), einer AlSn20Cu-Legierung, oder einer AlSn(24-26)Cu(2-3)-Legierung, insbesondere einer AlSn25Cu2,5-Legierung, gebildet ist.

6. Gleitlagerverbundwerkstoff nach einem oder mehreren der vorstehenden Ansprüche, **dadurch gekennzeichnet, dass** die Laufschicht (8) von einer AlBi-Legierung oder von einer SnCu- oder SnSb-Legierung oder von einer Bi-Legierung gebildet ist.

7. Gleitlagerverbundwerkstoff nach einem oder mehreren der vorstehenden Ansprüche, **dadurch gekennzeichnet, dass** die Dicke der Laufschicht (8) 5 - 25 µm, insbesondere 5 - 20 µm, insbesondere 6 - 18 µm, insbesondere 7 - 15 µm beträgt.

8. Gleitlagerverbundwerkstoff nach einem oder mehreren der vorstehenden Ansprüche, **dadurch gekennzeichnet, dass** die Kupferbasis-Schicht (6) Zinn und Nickel umfasst und die Laufschicht (8) ohne Zwischenordnung einer weiteren Diffusionssperrschicht direkt auf die Kupferbasis-Schicht (6) aufgesputtert ist.

9. Gleitlagerverbundwerkstoff nach einem oder mehreren der vorstehenden Ansprüche 1 bis 7, **dadurch gekennzeichnet, dass** die Kupferbasis-Schicht (6)eine CuSn-Legierung, insbesondere eine CuSn(4-10)-Legierung, umfasst und dass zwischen der Kupferbasis-Schicht (6) und der Laufschicht (8) eine Diffusionssperrschicht (10) einer Dicke von höchstens 10 µm, insbesondere von höchstens 8 µm, insbesondere von höchstens 6 µm vorgesehen ist.

10. Gleitlager, insbesondere Gleitlagerschale oder Gleitlagerbuchse, hergestellt aus einem Gleitlagerverbundwerkstoff nach einem oder mehreren der vorstehenden Ansprüche.

11. Verfahren zum Herstellen eines Gleitlagerverbundwerkstoffs (2) nach einem oder mehreren der vorstehenden Ansprüche 1 bis 9, beinhaltend folgende Merkmale:
- Bereitstellen einer Stützschicht (4), insbesondere aus Stahl,
- Ablängen von Platinenabschnitten der Stützschicht (4) und Einbringen der Platinenabschnitte in eine Kammer einer Sputteranlage,
- Reinigen der zu beschichtenden Oberfläche der Platinenabschnitte,
- Aufsputtern der Kupferbasis-Schicht (6) mit einer Schichtdicke von 20 µm - 80 µm,
- Aufsputtern der Laufschicht (8) auf Aluminiumbasis mit einer Schichtdicke von 5 - 25 µm.

## Claims

1. Metallic slide bearing compound material (2) with a support layer (4), in particular made of steel, a copper base layer (6) with tin or aluminium or nickel or Zink or combinations of the same and with a sputtered running surface (8) on an aluminium basis facing a slide partner, **characterised in that** the copper base layer (6) is a sputtered layer and has a thickness of 20 µm to 80 µm, and **in that** the copper base layer (6) is sputtered directly onto the support layer (4) or onto an interim layer with a thickness of less than 20 µm applied directly onto the support layer (4).

2. Slide bearing compound material according to claim 1, **characterised in that** the copper base layer (6) has a thickness of 25 µm to 70 µm, in particular of 30 µm to 70 µm, in particular of 30 µm to 60 µm, in particular of 30 µm to 50 µm.

3. Slide bearing compound material according to claim 1 or 2, **characterised in that** the copper base layer (6) is made of a CuSn (3-10)Ni(0-18) alloy, in particular of a CuSn(3-10)Ni(5-18) alloy, in particular of a CuSn(5-7)Ni(8-10) alloy or of a CuSn(7-10)Ni(13-16) alloy, in particular of a CuSn6Ni9 or a CuSn8Nil5 alloy.

4. Slide bearing compound material according to claim 1, 2 or 3, **characterised in that** the copper base layer (6) is made of a CuAl(4-10) alloy or of a CuZn(10-35) alloy.

5. Slide bearing compound material according to one or more of the preceding claims, **characterised in that** the running surface (8) is made of an AISn(17-27)Cu(0,5- 3) alloy, in particular of an AISn (18- 22)Cu(0,5-1,5), an AlSn2OCu alloy, or an AlSn (24-26)Cu(2-3) alloy, in particular an AlSn25Cu2,5 alloy.

6. Slide bearing compound material according to one or more of the preceding claims, **characterised in that** the running surface (8) is made of an Al bi-alloy or of an SnCu or SnSb alloy or of a bi-alloy.

7. Slide bearing compound material according to one or more of the preceding claims, **characterised in that** the thickness of the running surface (8) is 5-25 µm, in particular 5-20 µm, in particular 6-18 µm, in particular 7-15 µm.

8. Slide bearing compound material according to one or more of the preceding claims, **characterised in that** the copper base layer (6) comprises tin and nickel and the running surface (8) is sputtered directly onto the copper base layer (6) without a further diffusion blocking layer being applied therebetween.

9. Slide bearing compound material according to one or more of the preceding claims 1 to 7, **characterised in that** the copper base layer (6) comprises a CuSn alloy, in particular a CuSn(4-10) alloy, and **in that** a diffusion blocking layer (10) with a thickness of no more than 10 µm, in particular of no more than 8 µm, in particular of no more than 6 µm is envisaged between the copper base layer (6) and the running surface (8).

10. Slide bearing, in particular slide bearing shell or slide bearing bushing, manufactured from a slide bearing compound material according to one or more of the preceding claims.

11. Method for manufacturing a slide bearing compound materials (2) according to one or more of the preceding claims 1 to 9, including the following characteristics:
- provision of a support layer (4), in particular made of steel,
- cutting to length board sections of the support layer (4) and inserting the board sections into a chamber of the sputtering system,
- cleaning the surface of the board layer to be sputtered,
- sputtering on the copper base layer (6) with a layer thickness of 20 µm - 80 µm,
- sputtering the running surface (8) onto an aluminium base with a layer thickness of 5-25 µm.

## Revendications

1. Matériau composite de palier à glissement métallique (2) ayant une couche d'appui (4), en particulier en acier, une couche à base de cuivre (6) avec de l'étain ou de l'aluminium ou du nickel ou du zinc, ou des combinaisons de ceux-ci, et une couche de roulement (8) à base d'aluminium, appliquée par pulvérisation cathodique et faisant face à un partenaire de glissement,
**caractérisé en ce que** la couche à base en cuivre (6) est une couche appliquée par pulvérisation cathodique et présente une épaisseur de 20 µm à 80 µm, et **en ce que** la couche à base de cuivre (6) est appliquée par pulvérisation cathodique directement sur la couche d'appui (4) ou directement sur une couche intermédiaire déposée sur la couche d'appui (4), à une épaisseur inférieure à 20 µm.

2. Matériau composite de palier à glissement selon la revendication 1, **caractérisé en ce que** la couche à base de cuivre (6) a une épaisseur de 25 µm à 70 µm, en particulier de 30 µm à 70 µm, en particulier de 30 µm à 50 µm.

3. Matériau composite de palier à glissement selon la revendication 1 ou 2, **caractérisé en ce que** la couche à base de cuivre (6) est formée à partir d'un alliage CuSn(3-10)Ni(0-18), en particulier d'un alliage CuSn(3-10)Ni(5-18), en particulier d'un alliage CuSn(5-7)Ni(8-10) ou d'un alliage CuSn(7-10)Ni(13-16), en particulier d'un alliage CuSn6Ni9 ou CuSn8Ni15.

4. Matériau composite de palier à glissement selon la revendication 1, 2 ou 3, **caractérisé en ce que** la couche à base de cuivre (6) est formée d'un alliage CuAl(4-10) ou d'un alliage CuZn(10-35).

5. Matériau composite de palier à glissement selon une ou plusieurs des revendications précédentes, **caractérisé en ce que** la couche de roulement (8) est formée d'un alliage AlSn(17-27)Cu (0,5-3), en particulier d'un alliage AlSn(18-22)Cu(0,5-1,5), d'un alliage AlSn20Cu ou d'un alliage AlSn(24-26)Cu(2-3), en particulier d'un alliage AlSn25Cu2,5.

6. Matériau composite de palier à glissement selon une ou plusieurs des revendications précédentes, **caractérisé en ce que** la couche de roulement (8) est formée d'un alliage AlBi ou d'un alliage SnCu ou SnSb, ou d'un alliage de Bi.

7. Matériau composite de palier à glissement selon une ou plusieurs des revendications précédentes, **caractérisé en ce que** l'épaisseur de la couche de roulement (8) est comprise entre 5 et 25 µm, en particulier entre 5 et 20 µm, en particulier entre 6 et 18 µm, en particulier entre 7 et 15 µm.

8. Matériau composite de palier à glissement selon une ou plusieurs des revendications précédentes, **caractérisé en ce que** la couche à base de cuivre (6) présente de l'étain et du nickel, et la couche de roulement (8) est appliquée par pulvérisation cathodique directement sur la couche à base de cuivre (6) sans interposition d'une couche anti-diffusion supplémentaire.

9. Matériau composite de palier à glissement selon une ou plusieurs des revendications précédentes 1 à 7, **caractérisé en ce que** la couche à base de cuivre (6) comprend un alliage CuSn, en particulier un alliage CuSn(4-10), et **en ce qu'**entre la couche à base de cuivre (6) et la couche de roulement (8) est prévue une couche anti-diffusion (10) d'une épaisseur d'au plus 10 µm, en particulier d'au plus 8 µm, et en particulier d'au plus 6 µm.

10. Palier à glissement, en particulier coussinet de palier à glissement ou douille de palier à glissement, fabriqué en un matériau composite de palier à glissement selon une ou plusieurs des revendications précédentes.

11. Procédé de fabrication d'un matériau composite de palier à glissement (2) selon une ou plusieurs des revendications précédentes 1 à 9, comprenant les caractéristiques suivantes :
- fourniture d'une couche de support (4), en particulier en acier,
- découpage en longueur de tronçons de platine de la couche de support (4) et introduction des tronçons de platine dans une chambre d'un appareillage de pulvérisation cathodique,
- nettoyage de la surface à revêtir des tronçons de platine,
- pulvérisation cathodique de la couche à base de cuivre (6) avec une épaisseur de couche de 20 µm à 80 µm,
- pulvérisation cathodique de la couche de roulement (8) à base d'aluminium avec une épaisseur de couche de 5 à 25 µm.
